# EUROPÄISCHE PATENTSCHRIFT

(11) **EP 3 631 985 B1**
(45) Veröffentlichungstag und Bekanntmachung des Hinweises auf die Patenterteilung: **01.05.2024**
(21) Anmeldenummer: 18729343.6
(22) Anmeldetag: 18.05.2018
(51) Int. Cl.: H03H 17/08, H03K 5/15

(54) **VERFAHREN UND ANORDNUNG ZUR BREITBANDIGEN ERZEUGUNG VON IQ-SIGNALEN, INSBESONDERE IN MEHRKANAL-SYSTEMEN**
METHOD AND ARRANGEMENT FOR WIDEBAND GENERATION OF IQ SIGNALS, IN PARTICULAR IN MULTICHANNEL SYSTEMS
PROCÉDÉ ET DISPOSITIF POUR LA GÉNÉRATION DE SIGNAUX IQ DANS UNE BANDE DE FRÉQUENCE LARGE, EN PARTICULIER DANS DES SYSTÈMES MULTICANAUX

(30) Priorität: 26.05.2017 DE 102017208904
(43) Veröffentlichungstag der Anmeldung: 08.04.2020
(73) Patentinhaber: Fraunhofer-Gesellschaft zur Förderung der angewandten Forschung e.V., 80686 München (DE)
(72) Erfinder: WELP, Benedikt, 45134 Essen (DE); POHL, Nils, 53343 Wachtbert (DE)
(74) Vertreter: Gagel, Roland
(86) Internationale Anmeldenummer: PCT/EP2018/063074
(87) Internationale Veröffentlichungsnummer: WO 2018/215334

(56) Entgegenhaltungen:
- DE-C1- 3 836 396
- DE-C1- 19 926 358
- US-A1- 2011 200 161

## Beschreibung

### Technisches Anwendungsgebiet

Die vorliegende Erfindung betrifft ein Verfahren sowie eine Anordnung zur breitbandigen und synchronen Erzeugung von IQ-Signalen, insbesondere in mehrkanaligen Systemen, bei denen ein Referenzsignal zunächst in der Frequenz verdoppelt und anschließend einem Master-Slave-Flipflop zugeführt wird, um einen I-Anteil und einen Q-Anteil des Referenzsignals zu erhalten.

Für viele Anwendungen, egal ob in Radar- oder Kommunikationssystemen, sind Signale notwendig, die zueinander um 90° in der Phase verschoben sind. Derartige Signale werden auch als Quadratur- oder IQ-Signale bezeichnet. Man kann IQ-Signale zum Beispiel direkt über IQ-Oszillatoren oder aus einem Referenzsignal mit einem Phasenschieber erzeugen. Phasenschieber können dabei aktiv oder passiv realisiert werden. Passive Realisierungen haben den Nachteil, dass sie IQ-Signale nur schmalbandig erzeugen können. Demgegenüber bieten aktive Komponenten eine effiziente Möglichkeit, IQ-Signale extrem breitbandig zu generieren.

### Stand der Technik

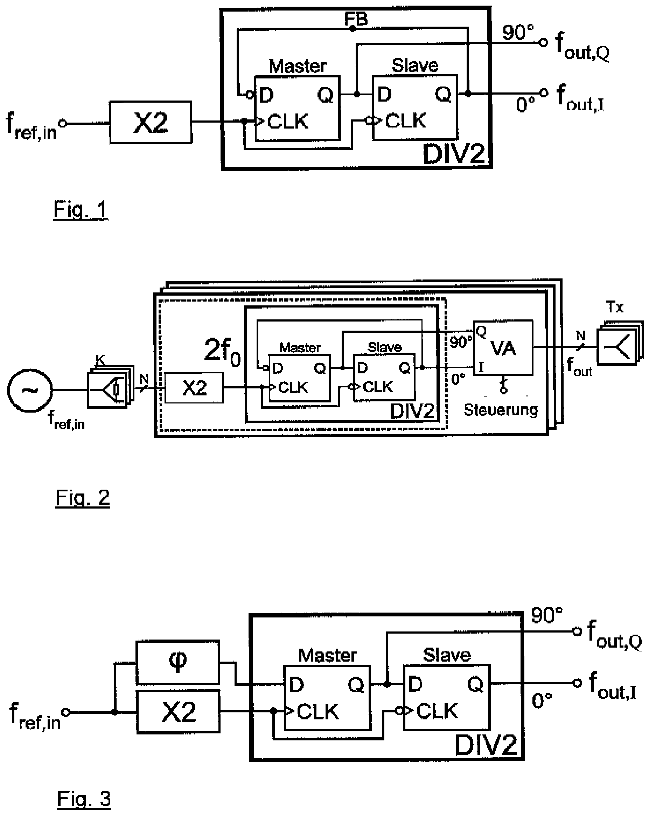

Für die Erzeugung breitbandiger IQ-Signale ist eine Anordnung bekannt, bei der ein Referenzsignal f_{ref,in} zunächst mit einem Frequenzverdoppler X2 in der Frequenz verdoppelt und anschließend mit einem statischen Teiler oder Master-Slave-D-Flipflop DIV2 wieder heruntergeteilt wird. Das Flipflop DIV2 enthält dabei das I- und das Q-Signal, welche jeweils an einen Ausgang als Ausgangssignale f_{out,Q}, f_{out,I} ausgegeben werden können. Eine derartige Anordnung ist beispielhaft in Figur 1 dargestellt.

Ein Nachteil dieser Anordnung besteht jedoch darin, dass derartige Flipflops, in Konfiguration als statischer Teiler, zum Teilen von Frequenzen eine Rückkopplung FB enthalten, die das Flipflop ohne Eingangssignal instabil macht, wodurch die Signalpfade im Flipflop schwingen. Wird ein derartiges Flipflop eingeschaltet oder das Signal kurz von seinem Eingang getrennt und anschließend wieder angelegt, entsteht eine Phasenunsicherheit der IQ-Signale f_{out,Q}, f_{out,I}, denn das Flipflop kann entweder in einem High- oder einem Low-Zustand als Anfangszustand einrasten. Dadurch erhalten die IQ-Signale entweder eine zusätzliche Phasenlage von 0° oder von 180°.

In einkanaligen Systemen ist diese Eigenschaft oft vernachlässigbar. In mehrkanaligen Systemen hingegen, in denen jeder einzelne Kanal oder ein Kanalbündel aus einem Referenzsignal jeweils eigene IQ-Signale erzeugen soll, führt dies zwangsläufig zu einer Asynchronizität der Kanäle, da die 0°/180°-Phasenunsicherheit der Flipflops in allen Kanälen zufällig verteilt ist. Somit entstehen Phasenfehler und die einzelnen Kanäle sind nicht mehr synchron zueinander. Figur 2 zeigt beispielhaft ein Blockschaltbild eines derartigen mehrkanaligen Systems. Das Eingangs-Referenzsignal f_{ref,in} wird zunächst durch ein Verteilnetzwerk K auf N Kanäle aufgeteilt. Für jeden dieser Kanäle erfolgt dann eine Verdopplung des Referenzsignals im Frequenzverdoppler X2 und anschließend ein Herunterteilen mit einem Master-Slave-D-Flipflop DIV2 als statischem Teiler, wodurch für jeden der Kanäle ein I- und ein Q-Anteil des Referenzsignals erhalten wird. Bei dem Beispiel der Figur 2 handelt es sich um ein Phased-Array Sendesystem, in dem die auf diese Weise erzeugten IQ-Signale genutzt werden, um mit einem Vektor-Addierer VA die Phase jedes Sendekanals so zu verschieben, dass sich die über die Antennen TX abgestrahlten Signale durch konstruktive Interferenz in beliebige Richtungen bündeln lassen. Der Vektor-Addierer VA wird hierzu über eine geeignete Steuerung (Control) angesteuert. Die Anwendung in Phased-Array Systemen ist besonders interessant, da sich durch Strahlformung (Beamforming) der Sendewellen die Systemdynamik und damit auch die Reichweite erhöhen lassen. Auch ein Einsatz in mehrkanaligen Empfängern, in denen Phasenschieber, Delays (verzögerte Phase) oder im Allgemeinen IQ-Signale für beliebige Zwecke benötigt werden, ist möglich.

Bei einer derartigen Anwendung, bei der die Synchronizität der einzelnen Kanäle von fundamentaler Bedeutung ist, verhindert die 0°/180°-Phasenunsicherheit der IQ-Signale jedoch die Einsetzbarkeit des klassischen Konzepts der Figur 1 für die genannten Beispiele. Betrachtet man das Phased-Array System aus Figur 2, so erzeugt die 0°/180°-Phasenunsicherheit destruktive Interferenzen der elektromagnetischen Sendewellen, wodurch die Systemperformance verschlechtert wird.

Daher wurden bisher zumeist schmalbandige und passive Komponenten verwendet, um IQ-Signale in mehrkanaligen Systemen zu erzeugen. Sobald jedoch ein etwas breitbandigerer Frequenzbereich abgedeckt werden soll, entstehen hier Abweichungen von der Soll-Phase der verarbeiteten Signale und die Systemperformance verschlechtert sich. Eine stabile und präzise Phase mit passiven Komponenten zu erzeugen, wird schwieriger, je größer der angestrebte Frequenzbereich ist.

Die JP 2005094113 A beschreibt eine Anordnung und ein Verfahren zur Erzeugung von IQ-Signalen, bei dem ein Referenzsignal zunächst in der Frequenz verdoppelt und anschließend einem Takt-Eingang eines Master-Slave-Flipflop zugeführt wird, um einen I-Anteil und einen Q-Anteil des Referenzsignals zu erhalten. Das Master-Slave-Flipflop wird hierbei ohne Rückkopplung betrieben.

Für das in der Figur 2 dargestellte mehrkanalige System ist es prinzipiell möglich, die IQ-Signale bereits direkt hinter dem Referenzoszillator, d.h. vor der Signalverteilung, zu erzeugen, womit der Phasenfehler von 0° oder 180° in allen Kanälen gleich und damit synchron wäre, allerdings steigt hierdurch der Verdrahtungsaufwand im Verteilnetzwerk und das Risiko für Phasenfehler der IQ-Signale durch diese Verdrahtung. Daher ist es optimal, wenn jeder Kanal seine eigenen IQ-Signale generiert, die eine exakte, stabile und breitbandige 90°-Phasenlage zueinander haben. So erhält der Vektor-Addierer nahezu perfekte IQ-Signale und Strahlformung wird für dieses Phased-Array System für einen großen Frequenzbereich möglich. Auch bei MIMO-Empfängern, bei denen jeder Kanal unterschiedliche Signale von verschiedenen Antennen empfängt, muss jeder Kanal eine separate IQ-Signalgenerierung besitzen, damit die Signale der einzelnen Kanäle synchron zueinander in Phase verschoben oder verzögert und so verarbeitet werden können.

Aus DE 199 26 358 C1 ist eine Schaltung zur Erzeugung von I- und Q-Signalen in einem einkanaligen System bekannt, bei der ein Eingangssignal zunächst eine Frequenzverdopplung und anschließend eine Frequenzteilung erfährt. Die Schaltung weist einen Phasendetektor auf, in dem die Phase des erzeugten I-bzw. Q-Signals mit der Phase des Eingangssignals verglichen und ein Steuersignal ausgegeben wird, das anzeigt, ob eine zusätzliche Phasenverschiebung um 180° vorliegt. In Abhängigkeit des Steuersignals wird das I-bzw. Q-Signal gegebenenfalls mittels einer Gilbertzelle invertiert.

Die Aufgabe der vorliegenden Erfindung besteht darin, ein Verfahren sowie eine Anordnung zur breitbandigen Erzeugung von IQ-Signalen ohne 0°/180°-Phasenunsicherheit anzugeben.

### Darstellung der Erfindung

Die Aufgabe wird mit den Verfahren und den Anordnungen gemäß den Patentansprüchen 1 und 4 gelöst. Vorteilhafte Ausgestaltungen des Verfahrens und der Anordnung sind Gegenstand der abhängigen Patentansprüche oder lassen sich der nachfolgenden Beschreibung sowie den Ausführungsbeispielen entnehmen.

Bei dem vorgeschlagenen Verfahren wird in bekannter Weise entsprechend dem bereits beschriebenen klassischen Konzept ein Referenzsignal zunächst in der Frequenz verdoppelt und anschließend dem Takt-Eingang eines Master-Slave-Flipflop, insbesondere eines Master-Slave-D-Flipflop, zugeführt, um einen I-Anteil und einen Q-Anteil des Referenzsignals zu erhalten. Zur Vermeidung der bei diesem Prinzip auftretenden Phasenunsicherheit werden zwei Lösungsvarianten vorgeschlagen, bei denen jeweils zusätzlich das Referenzsignal mit einer Phasenverschiebung bei der Signalverarbeitung genutzt wird.

Bei der erfindungsgemäßen ersten Lösungsvariante wird das Master-Slave-Flipflop ohne Rückkopplung betrieben. Stattdessen wird das Referenzsignal mit einer Phasenverschiebung am Daten-Eingang des Master-Slave-Flipflops eingespeist, wobei die Phasenverschiebung so gewählt wird, dass sie eine durch die Frequenzverdopplung verursachte frequenzabhängige Phasenverschiebung des am Takt-Eingang des Flipflops anliegenden frequenzverdoppelten Referenzsignals kompensiert. Zusätzlich ist die Phasenverschiebung so gewählt, dass beim vom Takt-Eingang gesteuerten Umschalten des Master-Slave-Flipflops (in den Beispielen wird ein flankengesteuertes Flipflop verwendet, welches bei einer Taktflanke umschaltet) ein definierter High- oder Low-Pegel am Daten-Eingang des Master-Slave-Flipflops anliegt, der dann vom Flipflop eingelesen werden kann. Durch diese aktive Einspeisung des phasenverschobenen Referenzsignals am Daten-Eingang ist zu jedem Zeitpunkt die Phasenlage des I-Anteils und des Q-Anteils am Ausgang des Master-Slave-Flipflops eindeutig festgelegt, so dass keine 0°/180°-Phasenunsicherheit mehr auftritt.

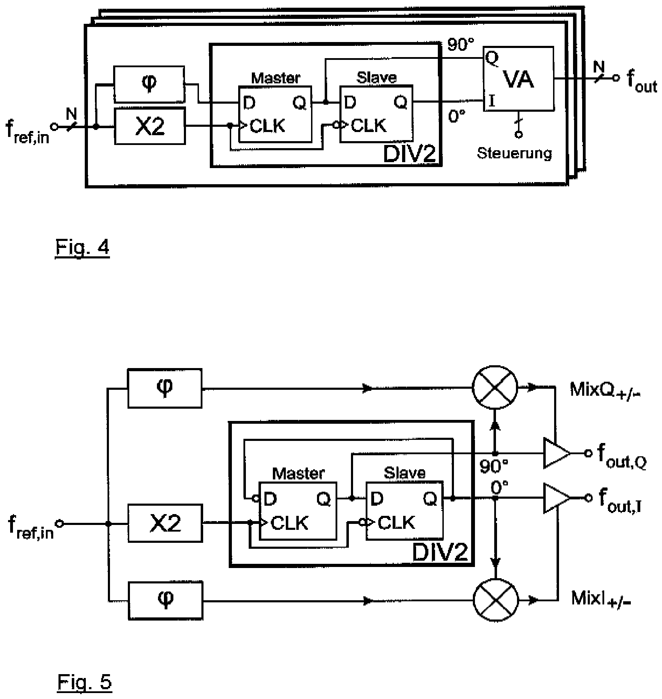

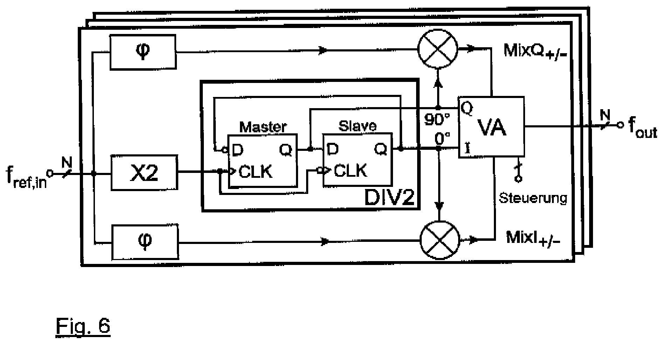

Bei der nicht erfindungsgemäßen zweiten Lösungsvariante wird das Master-Slave-Flipflop in bekannter Weise mit Rückkopplung in der Konfiguration als statischer Teiler betrieben. Bei dieser Variante wird das Referenzsignal zusätzlich mit einer Phasenverschiebung jeweils mit dem I-Anteil und/oder dem Q-Anteil am Ausgang des Master-Slave-Flipflops gemischt, wobei die Phasenverschiebung des Referenzsignals in diesem Fall so gewählt wird, dass sie die durch die Frequenzverdopplung und das anschließende Herunterteilen versursachte frequenzabhängige Phasenverschiebung zumindest annährend kompensiert. Die Amplitude des durch das Mischen erhaltenen Mischsignals des I-Anteils und des Q-Anteils mit dem phasenverschobenen Referenzsignal gibt dann Aufschluss darüber, ob die I- und Q-Anteile entweder nicht oder um 180° in der Phase gedreht vorliegen. Die Ausgangssignale der Mischer werden anschließend dazu genutzt, um die Phase der I- und Q-Signale zu korrigieren. Dies kann beispielsweise in der Kontrolllogik des Vektor-Addierers wie in Figur 6 oder mit Gilbert-Zellen als Verstärkern zur Phasendrehung wie in Figur 5 geschehen. Auch auf diese Weise wird somit sichergestellt, dass die am Ausgang der Anordnung bzw. durch das vorgeschlagene Verfahren erhaltenen I- und Q-Anteile bzw. der addierten I- und Q-Signale hinter dem Vektor-Addierer VA keine 0°/180°-Phasenunsicherheit mehr aufweisen.

Bei der zugehörigen Anordnung zur breitbandigen Erzeugung von IQ-Signalen mit einem oder mehreren Signalkanälen weist jeder Signalkanal einen Frequenzverdoppler und ein Master-Slave-Flipflop auf. Durch den Frequenzverdoppler wird ein am Signaleingang der Anordnung anliegendes Referenzsignal in der Frequenz verdoppelt und in den Takt-Eingang des Flipflops eingespeist. Durch das Flipflop wird dann an einem ersten Ausgang ein I-Anteil und an einem zweiten Ausgang ein Q-Anteil des Referenzsignals bereitgestellt.

In einer erfindungsgemäßen ersten Ausgestaltung zeichnet sich diese Anordnung dadurch aus, dass das Flipflop keinen Rückkopplungs-Pfad aufweist und der Daten-Eingang des Flipflops mit einer Einrichtung zur Erzeugung einer zusätzlichen Phase verbunden ist, deren Eingang mit dem Signaleingang der Anordnung verbunden ist. Die Einrichtung zur Erzeugung einer zusätzlichen Phase ist dabei derart ausgebildet, dass sie das am Signaleingang der Anordnung anliegende Referenzsignal mit einer zusätzlichen Phase versieht, die einerseits die durch die Frequenzverdopplung verursachte frequenzabhängige Phasenverschiebung zumindest annährend kompensiert und andererseits gewährleistet, dass bei einer Taktflanke am Takt-Eingang ein definierter High- oder Low-Pegel am Daten-Eingang anliegt, und mit dieser zusätzlichen Phase dem Daten-Eingang des Flipflops zuführt.

In der nicht erfindungsgemäßen zweiten Ausgestaltung weist das Flipflop in bekannter Weise den Rückkopplungs-Pfad zwischen dem Q-Ausgang des Slave und dem Daten-Eingang des Master auf. In dieser Ausgestaltung ist ebenfalls wenigstens eine Einrichtung zur Erzeugung einer zusätzlichen Phase vorgesehen, an deren Eingang das Referenzsignal anliegt. Der Ausgang dieser Einrichtung zur Erzeugung einer zusätzlichen Phase ist mit einem ersten Eingang eines Mischers verbunden, über dessen zweiten Eingang der am ersten oder zweiten Ausgang des Flipflops erhaltene I-Anteil oder Q-Anteil zugeführt wird. Der Mischer mischt somit den I-Anteil oder den Q-Anteil mit dem mit einer zusätzlichen Phase versehenen Referenzsignal. Die Einrichtung zur Erzeugung einer zusätzlichen Phase ist dabei wiederum so ausgebildet, dass sie das Referenzsignal mit einer zusätzlichen Phase versieht, die die durch die Frequenzverdopplung und das Herunterteilen verursachte frequenzabhängige Phasenverschiebung zumindest annähernd kompensiert. Das am Ausgang des Mischers erhaltene Ausgangs- bzw. Mischsignal dient als Eingangssignal für eine Einrichtung zur Phasenkorrektur um 0° oder 180°, mit der jeweils der erste Ausgang mit I-Signalanteil und der zweite Ausgang mit Q-Signalanteil des Flipflops verbunden sind. Diese Einrichtung zur Phasenkorrektur ist so ausgebildet, dass sie die Phase des I-Anteils und des Q-Anteils in Abhängigkeit vom Ausgangsignal des Mischers entweder nicht oder um 180° dreht bzw. entsprechend korrigiert. Bei dieser Einrichtung kann es sich beispielsweise um eine Gilbert-Zelle handeln, eine für den ersten und eine für den zweiten Ausgang des Flipflops, die das I- oder Q-Signal entweder mit +1 oder -1 multipliziert und so um 0° oder 180° verschiebt. Alternativ - beispielsweise bei Nutzung in einem Phased-Array System - kann auch ein Vektor-Addierer genutzt werden, der die Phasenlage der I- und Q-Signale kennt und in dessen Kontrolllogik dies bei der Einstellung der gewünschten Phasenlage in jedem Kanal berücksichtigt und entsprechend kompensiert wird.

Mit dem Verfahren und der zugehörigen Anordnung werden in jedem Kanal eines mehrkanaligen Sende- oder Empfangssystems synchrone IQ-Signale erhalten, die in der Phase sehr stabil und präzise über einen extrem großen Frequenzbereich sind und beispielsweise mit einem Vektor-Addierer dazu genutzt werden können, die Signalphase jedes Kanals gezielt zu verschieben. Die untere Grenzfrequenz liegt hierbei bei 0 Hz und die obere Grenzfrequenz ist nur durch die Komponente des Systems mit der geringsten maximalen Arbeitsfrequenz bestimmt. So konnten in einer bereits umgesetzten Realisierung beider Lösungen in einer Silizium-Germanium Technologie Frequenzen von über 30 GHz erreicht werden. Durch weitere Optimierungen oder andere Halbleiter-Technologien wie bspw. InP, GaAs, etc. können auch höhere Frequenzen erreicht werden. Bereits veröffentlichte Publikationen zeigen Schaltungskomponenten in Silizium-Germanium, die 60 GHz und mehr als obere Grenzfrequenz erreicht haben. Mit dem vorgeschlagenen Verfahren und der zugehörigen Anordnung wird somit eine Signal-Synchronizität und extrem hohe Bandbreite für mehrkanalige Systeme erreicht, in denen IQ-Signalgenerierung benötigt wird.

Das Verfahren und die zugehörige Anordnung lassen sich in allen Anwendungen einsetzen, in denen jeder Kanal eines mehrkanaligen Systems eine stabile und breitbandige IQ-Signalgenerierung benötigt, die synchron zu allen anderen Kanälen ist. Dies ist beispielsweise in Phased-Array-Kanälen der Fall, um mit Vektor-Addierern Strahlformung zu betreiben. Strahlformung kann bei allen Sendesystemen (Radar, Mobilfunk, etc.) eingesetzt werden. Auch auf Empfängerseite von (insb. mehrkanaligen) Radar- oder Mobilfunksystemen, wo jeder Empfangskanal Signale einer anderen Antenne empfängt und diese Signale in jedem Kanal in der Phase verschoben, moduliert oder demoduliert werden sollen, kann das vorgeschlagene Verfahren bzw. die vorgeschlagene Anordnung eingesetzt werden. Beispiele hierfür sind der Einsatz in (insb. mehrkanaligen) Kommunikationssystemen (z.B. bei Verfahren, die orthogonale Träger verwenden (OFDM), QAM, Rake-Receiver) und Radarsystemen (z.B. bei Phased-Array Beamforming, IQ-Receiver für Image Rejection), jeweils auf Sender- und Empfängerseite.

### Kurze Beschreibung der Zeichnungen

Das vorgeschlagene Verfahren und die zugehörige Anordnung werden nachfolgend anhand von Ausführungsbeispielen in Verbindung mit den Zeichnungen nochmals näher erläutert. Hierbei zeigen:
- Fig. 1: ein Beispiel für eine klassische breitbandige IQ-Signalgenerierung gemäß dem Stand der Technik (enthält 0°/180°-Phasenunsicherheit der I- und Q-Ausgangssignale);
- Fig. 2: ein Beispiel für eine klassische breitbandige IQ-Signalgenerierung für ein Phased-Array Sendesystem gemäß dem Stand der Technik;
- Fig. 3: ein erstes Beispiel für eine Anordnung zur breitbandigen IQ-Signalgenerierung gemäß dem vorgeschlagenen erfindungsgemäßen Verfahren;
- Fig. 4: das Beispiel der Figur 3 in einem mehrkanaligen Phased-Array Sendesystem;
- Fig. 5: ein nicht erfindungsgemäßes zweites Beispiel für eine Anordnung zur breitbandigen IQ-Signalgenerierung; und
- Fig. 6: das Beispiel der Figur 5 in einem mehrkanaligen Phased-Array Sendesystem.

### Wege zur Ausführung der Erfindung

Figur 1 zeigt eine Anordnung für die klassische breitbandige IQ-Signalgenerierung, bei der ein Referenzsignal f_{ref,in} zunächst in einem Frequenzverdoppler X2 in der Frequenz verdoppelt und anschließend mit einem Master-Slave-D-Flipflop DIV2 wieder heruntergeteilt wird. Das Flipflop enthält dabei das I- und das Q-Signal welche als Ausgangssignale f_{out,Q}, f_{out,I} ausgegeben werden können. Das frequenzverdoppelte Eingangssignal wird dabei in bekannter Weise mit den Takt-Eingängen CLK des Master und des Slave verbunden. Der Q-Ausgang des Slave ist über einen Rückkopplungs-Pfad FB mit dem Daten-Eingang D des Master verbunden. Wie bereits im einleitenden Teil erläutert wurde, tritt bei einem derartigen System eine Phasenunsicherheit der IQ-Signale am Ausgang auf, die entweder eine Phasenlage von 0° oder eine zusätzliche Phasenlage von 180° erhalten.

Figur 2 zeigt ein mehrkanaliges System gemäß dem Stand der Technik, bei dem diese Anordnung in jedem Kanal zur Generierung der IQ-Signale eingesetzt wird. Durch die 0°/180°-Phasenunsicherheit der Flipflops, die in allen Kanälen zufällig auftritt, entstehen Phasenfehler und die einzelnen Kanäle sind nicht mehr synchron. Gerade in einem Phased-Array Sendesystem, wie es in der Figur 2 dargestellt ist, führt diese Phasenunsicherheit zu unerwünschten destruktiven Interferenzen der elektromagnetischen Sendewelle.

Figur 3 zeigt nun ein erstes Beispiel einer erfindungsgemäßen Anordnung, mit der die oben beschriebenen Phasenunsicherheiten vermieden werden. Bei der Anordnung der Figur 3 wurde der Rückkopplungs-Pfad des als statischer Teiler eingesetzten Master-Slave-D-Flipflops DIV2 im Vergleich zu Figur 1 entfernt und stattdessen das Referenzsignal f_{ref,in} mit dem Daten-Eingang D des Master über eine Einrichtung ϕ zur Erzeugung einer zusätzlichen Phase verbunden. Das Flipflop wird jetzt als echtes Flipflop zur Signalsynchronisierung mit dem Takt (verdoppeltes Referenzsignal hinter dem Frequenzverdoppler X2) genutzt. Hierbei ist es erforderlich, den mit der Frequenz variierenden Phasenversatz, der durch den Frequenzverdoppler X2 entsteht, zu kompensieren, indem auch das Referenzsignal mit Hilfe einer Schaltung, der Einrichtung ϕ, um in etwa denselben Phasenversatz verzögert wird. Es ist wichtig, dass bei einer Flanke am Takt-Eingang CLK des Flipflops ein stabiler Zustand des Referenzsignals am Daten-Eingang D des Flipflops anliegt und nicht ebenfalls eine Flanke des Referenzsignals. Der zur Kompensation erzeugte Phasenversatz wird daher diesbezüglich entsprechend angepasst. Am Ausgang des D-Flipflops werden dann der I-Anteil des Referenzsignals f_{out,I} und der Q-Anteil des Referenzsignals f_{out,Q} ohne die 0°/180°-Phasenunsicherheit erhalten. Als Frequenzverdoppler X2 kann beispielsweise eine Gilbert-Zelle eingesetzt werden, die das Eingangssignal mit sich selbst mischt und so verdoppelt. Als Einrichtung ϕ zur Erzeugung der zusätzlichen Phase kann beispielsweise eine oder mehrere Emitterschaltungen mit Lastwiderständen oder komplexen Lastimpedanzen verwendet werden, um den (frequenzabhängigen) Phasenversatz des Referenzsignals, das die anderen Komponenten (X2 und evtl. Teile des Flipflops) durchläuft, nachzumodellieren.

In dem Beispiel der Figur 4 wird die in Figur 3 beschriebene Anordnung in einem mehrkanaligen Phased-Array Sendesystem eingesetzt, wie sie bereits in Verbindung mit Figur 2 beschrieben wurde. Die Vektor-Addierer VA erhalten nun in jedem Kanal IQ-Signale, die synchron zu denen der anderen Kanäle sind. Dadurch können die abgestrahlten Signale dieses Phased-Array Systems durch Strahlformung in bestimmte Richtungen gebündelt werden. Der Vektor-Addierer VA wird hierzu in bekannter Weise über eine Steuerung (Control) angesteuert.

Figur 5 zeigt ein nicht-erfindungsgemäßes Beispiel für eine Ausgestaltung einer Anordnung bzw. eines Verfahrens. In diesem Beispiel wird das D-Flipflop als statischer Teiler DIV2 mit dem Rückkopplungs-Pfad FB betrieben. Bei dieser Lösung wird allerdings jeweils ein Abwärtsmischer MixQ, MixI eingesetzt, um das um eine Phase verschobene Referenzsignal f_{ref,in} mit dem I- oder dem Q-Signal des statischen Teilers DIV2 zu mischen. Auch hier ist es wieder wichtig, das Referenzsignal mit einer geeigneten Einrichtung ϕ um dieselbe Phase zu verzögern wie das Signal, das durch den Frequenzverdoppler X2 und den Teiler DIV2 läuft, um die Breitbandigkeit der IQ-Signalgenerierung zu gewährleisten. Die IQ-Signale enthalten hierbei zunächst nach wie vor am Ausgang des Teilers DIV2 die 0°/180°-Phasenunsicherheit. Am Ausgang der Mischer MixQ, MixI erhält man dann je nach Phasenlage der I- und Q-Signale (entweder 0° oder 180°) ein DC-Signal, welches entweder "High" oder "Low" ist. Diese Information wird anschließend dazu genutzt, um einen der beiden möglichen Phasenlagen der IQ-Signale (zum Beispiel 180°) zu kompensieren. Dies kann beispielsweise, wie in Figur 5 dargestellt, mit Verstärkern erfolgen, die das Signal bei Bedarf um 180° drehen. Beispielsweise kann hierzu eine Gilbert-Zelle eingesetzt werden, die das I- oder Q-Signal mit +1 oder -1 multipliziert/mischt. Eine weitere Möglichkeit zur Kompensation ist in Figur 6 anhand des bekannten Phased-Array Systems gezeigt. Hier wird die Information über die Phasenlage der IQ-Signale über die Mischer MixQ/MixI dem Vektor-Addierer VA übergeben, in dessen Kontrolllogik (Control) die Phasenänderung zu seinem Ausgang hin so eingestellt wird, dass die Phasenunsicherheit kompensiert und die gewünschte Phasenlage der Sendesignale eingestellt wird. Somit werden auch bei dieser Ausgestaltung alle IQ-Signale in allen Kanälen eines mehrkanaligen Systems auf das Referenzsignal synchronisiert.

### Bezugszeichenliste

- X2: Frequenzverdoppler
- DIV2: Statischer Teiler/Master-Slave-D-Flipflop
- FB: Rückkopplung
- D: Daten-Eingang
- CLK: Takt-Eingang
- Q: Q-Ausgang
- K: Verteilernetzwerk
- N: Anzahl der Kanäle
- TX: Sendeantennen
- VA: Vektor-Addierer
- ϕ: Einrichtung zur Erzeugung einer zusätzl. Phase
- MixI: Mischer
- MixQ: Mischer

## Patentansprüche

1. Verfahren zur breitbandigen Erzeugung von IQ-Signalen, bei dem ein Referenzsignal zunächst in der Frequenz verdoppelt und anschließend einem Takt-Eingang (CLK) eines Master-Slave-Flipflop (DIV2) zugeführt wird, um einen I-Anteil und einen Q-Anteil des Referenzsignals zu erhalten, **dadurch gekennzeichnet, dass**
das Master-Slave-Flipflop (DIV2) ohne Rückkopplung betrieben wird,
wobei das Referenzsignal zusätzlich mit einer Phasenverschiebung am Daten-Eingang (D) des Master-Slave-Flipflops (DIV2) eingespeist wird, um das in der Frequenz verdoppelte Referenzsignal mit dem um die zusätzliche Phase verschobenen Referenzsignal zu synchronisieren, wobei die Phasenverschiebung so gewählt wird, dass sie eine durch die Frequenzverdopplung verursachte Phasenverschiebung zumindest annähernd kompensiert und zusätzlich gewährleistet, dass bei Anliegen einer Flanke des in der Frequenz verdoppelten Referenzsignals am Takt-Eingang (CLK) ein definierter High- oder Low-Pegel des Referenzsignals am Daten-Eingang (D) des Master-Slave-Flipflops (DIV2) anliegt.

2. Verfahren nach Anspruch 1,
**dadurch gekennzeichnet,**
**dass** das Referenzsignal für den Betrieb eines mehrkanaligen Systems in mehrere Kanäle aufgeteilt wird, wobei die Frequenzverdopplung und das Herunterteilen oder Synchronisieren in jedem der Kanäle erfolgen, um für jeden Kanal einen I-Anteil und einen Q-Anteil des Referenzsignals synchron zu den anderen Kanälen zu erzeugen.

3. Verfahren nach Anspruch 2,
**dadurch gekennzeichnet,**
**dass** der erzeugte I-Anteil und der erzeugte Q-Anteil in jedem der Kanäle einem Vektor-Addierer (VA) für den Betrieb eines Phased-Array Systems zugeführt werden.

4. Anordnung zur breitbandigen Erzeugung von IQ-Signalen mit einem oder mehreren Signalkanälen, **dadurch gekennzeichnet, dass** jeder Signalkanal einen Frequenzverdoppler (X2) und ein Master-Slave-Flipflop (DIV2) ohne Rückkopplungs-Pfad aufweist,
wobei ein Signaleingang der Anordnung zusätzlich über eine Einrichtung zur Erzeugung einer zusätzlichen Phase (ϕ) mit einem Daten-Eingang (D) des Master-Slave-Flipflops (DIV2) verbunden ist und der Frequenzverdoppler (X2) und das Master-Slave-Flipflop (DIV2) so ausgebildet und verschaltet sind, dass ein am Signaleingang der Anordnung anliegendes Referenzsignal durch den Frequenzverdoppler (X2) in der Frequenz verdoppelt und anschließend einem Takt-Eingang (CLK) des Master-Slave-Flipflops (DIV2) zugeführt wird, durch das das in der Frequenz verdoppelte Referenzsignal mit dem um die zusätzliche Phase verschobenen Referenzsignal am Daten-Eingang (D) des Master-Slave-Flipflops (DIV2) synchronisiert wird und an einem ersten Ausgang des Master-Slave-Flipflops (DIV2) ein I-Anteil und an einem zweiten Ausgang ein Q-Anteil des Referenzsignals bereitgestellt wird,
wobei die Einrichtung zur Erzeugung einer zusätzlichen Phase (ϕ) so ausgebildet ist, dass sie ein am Signaleingang der Anordnung anliegendes Referenzsignal mit einer Phasenverschiebung versieht, die eine durch die Frequenzverdopplung verursachte Phasenverschiebung zumindest annähernd kompensiert und zusätzlich gewährleistet, dass bei Anliegen einer Flanke des in der Frequenz verdoppelten Referenzsignals am Takt-Eingang (CLK) ein definierter High- oder Low-Pegel des Referenzsignals am Daten-Eingang (D) des Master-Slave-Flipflops (DIV2) anliegt.

## Claims

1. Method for wideband generation of IQ signals, in which a reference signal is first doubled in frequency and then fed to a clock input (CLK) of a master-slave-flipflop (DIV2) to obtain an I-component und a Q-component of the reference signal,
**characterized in that**
the master-slave-flipflop (DIV2) is operated without feedback,
wherein
the reference signal is additionally fed in with a phase shift at the data input (D) of the master-slave-flipflop (DIV2), in order to synchronise the reference signal of which the frequency is doubled with the reference signal that has been shifted by the additional phase, wherein the phase shift is selected such that it at least approximately compensates for a phase shift caused by the frequency doubling and also ensures that when a flank of the frequency-doubled reference signal is present at the clock input (CLK) a defined high level or low level of the reference signal is present at the data input (D) of the master-slave-flipflop (DIV2).

2. Method according to Claim 1,
**characterized in that**
the reference signal for operating a multichannel system is split into multiple channels, wherein the frequency doubling and the dividing down or synchronising take place in each of the channels, in order to generate an I-component and a Q-component of the reference signal for each channel in synchronisation with the other channels.

3. Method according to Claim 2,
**characterized in that**
the I-component generated and the Q-component generated are fed to a vector adder (VA) in each of the channels for operation of a phased array system.

4. Arrangement for wideband generation of IQ signals with one or more signal channels,
**characterized in that**
each signal channel includes a frequency doubler (X2) and a master-slave-flipflop (DIV2) without a feedback path,
wherein
a signal input of the arrangement is additionally connected to a data input (D) of the master-slave-flipflop (DIV2) via a device for generating an additional phase (ϕ), and the frequency doubler (X2) and the master-slave-flipflop (DIV2) are designed and connected in such a way that a reference signal present at the signal input of the arrangement is doubled in frequency by the frequency doubler (X2) and then supplied to a clock input (CLK) of the master-slave-flipflop (DIV2), by which the frequency-doubled reference signal is synchronised with the reference signal that is shifted by the additional phase at the data input (D) of the master-slave-flipflop (DIV2), and an I-component is provided at a first output of the master-slave-flipflop (DIV2) and a Q-component of the reference signal is provided at a second output,
wherein the device for generating an additional phase (ϕ) is designed such that it induces a phase shift on a reference signal at the signal input of the arrangement, which shift at least approximately compensates for a phase shift caused by the frequency doubling, and also ensures that when a flank of the frequency-doubled reference signal is present at the clock input (CLK) a defined high level or low level of the reference signal is present at the data input (D) of the master-slave-flipflop (DIV2).

## Revendications

1. Procédé de génération de signaux QI à large bande, dans lequel un signal de référence double d'abord en fréquence, et est ensuite introduit dans une entrée d'horloge (CLK) d'une bascule maître-esclave (DIV2), afin d'obtenir une composante I et une composante Q du signal de référence,
**caractérisé en ce que**
la bascule maître-esclave (DIV2) fonctionne sans rétroaction,
dans lequel
le signal de référence est alimenté dans l'entrée de données (D) de la bascule maître-esclave (DIV2) avec en outre un déphasage afin de synchroniser le signal de référence dont la fréquence a été doublée avec le signal de référence décalé de la phase supplémentaire, dans lequel le déphasage est sélectionné de telle sorte qu'il compense au moins approximativement un déphasage provoqué par le doublage de fréquence et garantit en outre que, en présence d'un flanc du signal de référence doublé en fréquence sur l'entrée d'horloge (CLK) un niveau haut ou bas défini du signal de référence est présent au niveau de l'entrée de données (D) de la bascule maître-esclave (DIV2).

2. Procédé selon la revendication 1,
**caractérisé en ce que**
le signal de référence pour le fonctionnement d'un système de canaux multiples est divisé en plusieurs canaux, dans lequel le doublage de fréquence et le fractionnement ou une synchronisation a lieu dans chacune des canaux, afin de générer pour chaque canal une composante I et une composante Q du signal de référence synchrone par rapport aux autres canaux.

3. Procédé selon la revendication 2,
**caractérisé en ce que**
la composante I générée et la composante Q générée sont introduites dans chacun des canaux dans un additionneur vectoriel (VA) pour le fonctionnement d'un système multiéléments.

4. Agencement pour la génération de signaux QI à large bande avec un ou plusieurs canaux de signal,
**caractérisé en ce que**
chaque canal de signal possède un doubleur de fréquence (X2) et une bascule maître-esclave (DIV2) sans trajet de rétroaction,
dans lequel
une entrée de signal du dispositif est en outre connectée via un dispositif de génération d'une phase supplémentaire (ϕ) à une entrée de données (D) de la bascule maître-esclave (DIV2) et le doubleur de fréquence (X2) et la bascule esclave maître (DIV2) sont conçus et connectés de telle manière qu'un signal de référence présent à l'entrée de signal de l'agencement soit doublé en fréquence par le doubleur de fréquence (X2) puis envoyé à une entrée d'horloge (CLK) de la bascule maître-esclave (DIV2), via laquelle le signal de référence à fréquence doublée est synchronisé avec le signal de référence décalé de la phase supplémentaire au niveau de l'entrée de données (D) de la bascule maître-esclave (DIV2) et une composante I est fournie à une première sortie de la bascule maître-esclave (DIV2) et une composante Q du signal de référence est fournie à une deuxième sortie,
dans lequel le dispositif de génération d'une phase supplémentaire (ϕ) est conçu de manière à doter un signal de référence présent à l'entrée de signal de l'agencement d'un déphasage, qui compense au moins approximativement un déphasage provoqué par le doublement de fréquence et garantit en outre que lorsqu'un front du signal de référence doublé en fréquence est présent à l'entrée d'horloge (CLK), un niveau haut ou bas défini du signal de référence est présent à l'entrée de données (D) de la bascule maître esclave (DIV2).
